# EUROPEAN PATENT SPECIFICATION

(11) **EP 0 405 660 B1**
(45) Date of publication and mention of the grant of the patent: **26.04.1995**
(21) Application number: 90201625.2
(22) Date of filing: 21.06.1990
(51) Int. Cl.: H01L 21/60, H01L 21/768

(54) **A method of manufacturing a semiconductor device**
Verfahren zum Herstellen einer Halbleitervorrichtung
Procédé de fabrication d'un dispositif semiconducteur

(30) Priority: 26.06.1989 GB 8914626
(43) Date of publication of application: 02.01.1991
(73) Proprietor: Philips Electronics N.V., 5621 BA Eindhoven (NL)
(72) Inventor: Verhaar, Robertus Dominicus Joseph, NL-5656 AA Eindhoven (NL); De Bruin, Leendert, NL-5656 AA Eindhoven (NL)
(74) Representative: Stevens, Brian Thomas

(56) References cited:
- EP-A- 0 182 998
- EP-A- 0 195 977
- EP-A- 0 224 699
- EP-A- 0 257 948
- EP-A- 0 262 719
- EP-A- 0 262 719

## Description

The invention relates to a method of manufacturing a semiconductor device, which method comprises providing a semiconductor body having adjacent one major surface a device region bounded by an insulating region, providing electrical connection to the device region by applying a flowable organic material to form an organic layer on the one major surface, defining a masking layer over the organic layer, etching the organic layer selectively with respect to the underlying device and insulating regions through a window in the masking layer to form an opening exposing a contact area of the device region, and depositing electrically conductive material to form a conductive pillar within the opening in contact with the contact area.

Such a method is described in EP-A-0195977. As described in EP-A-0195977, the flowable material for forming the organic layer comprises a layer of polyimide which is spun onto the one major surface so providing a relatively flat surface. An oxide layer is provided on the polyimide layer and is followed by a photosensitive resist which is developed to form the masking layer through which the organic layer is etched using a wet or a dry etchant. Tungsten is then selectively deposited to form the conductive pillar in the opening etched in the dielectric by chemical vapour deposition using WF₆ and H₂. A nucleation layer may be provided in the opening to facilitate tungsten deposition by using, for example, a lift-off technique. After formation of the conductive pillar a further layer of polyimide is spun onto the surface and the above-mentioned steps repeated. Where it is desired, as shown in Figure 8 of EP-A-0195977, to interconnect two or more pillars by a second metallisation level, then a nucleation layer will normally be required to enable selective deposition of tungsten over the first polyimide layer. This process may be repeated one or more further times depending on the desired number of metallisation levels. This method relies on the spun-on polyimide layers to provide the insulating or dielectric material which isolates conductive pillars from one another so that only the desired electrical connections are made.

EP-A-182 998 describes a method of making metal contact studs between first level metallisation and regions of a semiconductor device using a lift-off process. It is essential in the method of EP-A-182 998 that the material used to form the lift-off mask does not attack the organic material, which may be polyimide, filling the deep trenches which provide the isolation for the semiconductor device. Accordingly, EP-A-182 998 uses a photoresist such as a diazo resist to form the lift-off mask, so enabling the lift-off mask pattern to be defined without attacking the organic material filling the deep trenches even where the windows opened in the photoresist lift-off layer overlap onto and so expose the organic material filling the isolation trenches. After deposition of the conductive material, the photoresist is removed to lift-off the undesired portions of the conductive material. A layer of silicon dioxide is then deposited to form the insulation between the metal contact studs.

EP-A-224 699 is concerned with a method of forming fine conductive lines, patterns and connectors which is said to avoid the disadvantages of lift-off processes. Thus, in the methods described in EP-A-224 699, conductive material is applied to a patterned polymeric material applied to a substrate and excess conductive material is then removed using a chemical-mechanical process which avoids the need for a lift-off process. The polymeric material may then be left in place as an insulator or replaced by a more suitable material.

As described in EP-A-224 699 it is possible to use more than one layer of polymeric material where the underlying layer is an insulator and the top layer is a photoresist. In the described example, the first or underlying insulating polymeric material comprises polyimide while the photoresist comprises a novolak photoresist which has been subjected to a silylating process. Because the silylated photoresist is a good insulator and has a dielectric constant which is nearly as high as that of the polyimide, the silylated photoresist may either be left in place or alternatively removed so that the metal extends above the remaining insulating polymeric layer.

Polyimide is, however, susceptible to cracking and contamination and therefore may not provide sufficiently good insulation so that short-circuits may, for example, occur.

It is an object of the present invention to provide a method of manufacturing a semiconductor device which enables good electrical connection to a device region whilst avoiding or at least reducing the above-mentioned problems.

According to the present invention, there is provided a method of manufacturing a semiconductor device, which method comprises providing a semiconductor body having adjacent one major surface a device region bounded by an insulating region, providing an electrical connection to the device region by applying a flowable organic insulating material to form an organic insulating layer on the one major surface, defining a masking layer over the organic insulating layer, etching the organic insulating layer selectively with respect to the underlying device and insulating regions through a window in the masking layer to form an opening through the organic insulating layer which exposes a contact area of the device region, selectively depositing electrically conductive material in the opening to form within the opening a conductive pillar contacting the contact area, removing the masking layer, removing the organic insulating layer so that the side surfaces of the conductive pillar are exposed, providing a layer of insulating material to cover the pillar, etching back the insulating layer to expose a top surface of the pillar and depositing electrically conductive material to contact the pillar.

It should be understood that, as used herein, the term 'flowable insulating organic material' means any suitable carbon-containing insulating polymer which can be etched easily in, for example, an oxygen-containing plasma.

Using a method embodying the invention enables the advantages of using a flowable insulating organic material such as polyimide to be obtained, namely the fact that the application of a flowable organic insulating material enables the contact hole or opening to be etched with a high (usually almost infinite) selectivity with respect to the underlying device and insulating regions so that very little, if any, of the underlying material is removed by the etching of the opening or contact hole enabling the contact hole or opening to overlap onto gate isolation or field oxide without risk of undesired short-circuits between, for example, an insulated gate and a device region being contacted by the pillar, whilst avoiding or at least reducing the problems of cracking and/or contamination which may occur when a flowable material such as polyimide is used as an insulating layer.

Furthermore, using a method embodying the invention should reduce potential alignment problems because the electrically conductive material for contacting the conductive pillar is deposited directly onto the pillar, and then may be patterned as desired, so ensuring good electrical contact with the pillar.

A nucleation layer, such as a layer of amorphous silicon or a titanium-tungsten alloy where the semiconductor device is a silicon device and the selectively deposited conductive material is tungsten, may be provided on the one major surface prior to applying the flowable organic insulating material to facilitate growth of the conductive pillar on the contact area, irrespective of the material originally present at the contact area, and without an increased risk of undesired electrical short-circuits because exposed portions of the nucleation layer may be removed after removal of the organic layer.

Generally, in a method embodying the invention, the masking layer is defined as a layer of a material selected from the group consisting of silicon oxide, silicon nitride and borophosphosilicate glass and spin-on-glass and the organic insulating layer is etched through the masking layer using a reactive ion etching process enabling the opening exposing the contact area to be precisely defined and to have straight side walls, which features are particularly important for very large scale integration where the opening or contact hole may be less than a micrometre in width or diameter.

The insulating layer may be provided by depositing a layer of silicon oxide, applying a resist layer on the silicon oxide layer to provide a flatter surface and then etching the insulating layer so that the silicon oxide and resist are etched at the same rate thereby providing a relatively flat surface upon exposure of the top surface of the conductive pillar, so enabling the provision of a relatively flat insulating layer formed from an insulating material having good insulating properties which is less susceptible to contamination and cracking than a flowable organic material such as polyimide.

Embodiments of the invention will now be described, by way of example, with reference to the accompanying drawings, in which:
Figures 1 to 5 are cross-sectional views of part of a semiconductor device for illustrating a first embodiment of a method in accordance with the invention; and
Figure 6 is a cross-sectional view similar to Figures 1 to 5 for illustrating a second embodiment of a method in accordance with the invention.

It should be understood that the Figures are merely schematic and are not drawn to scale. In particular certain dimensions such as the thickness of layers or regions may have been exaggerated whilst other dimensions may have been reduced. It should also be understood that the same reference numerals are used throughout the Figures to indicate the same or similar parts.

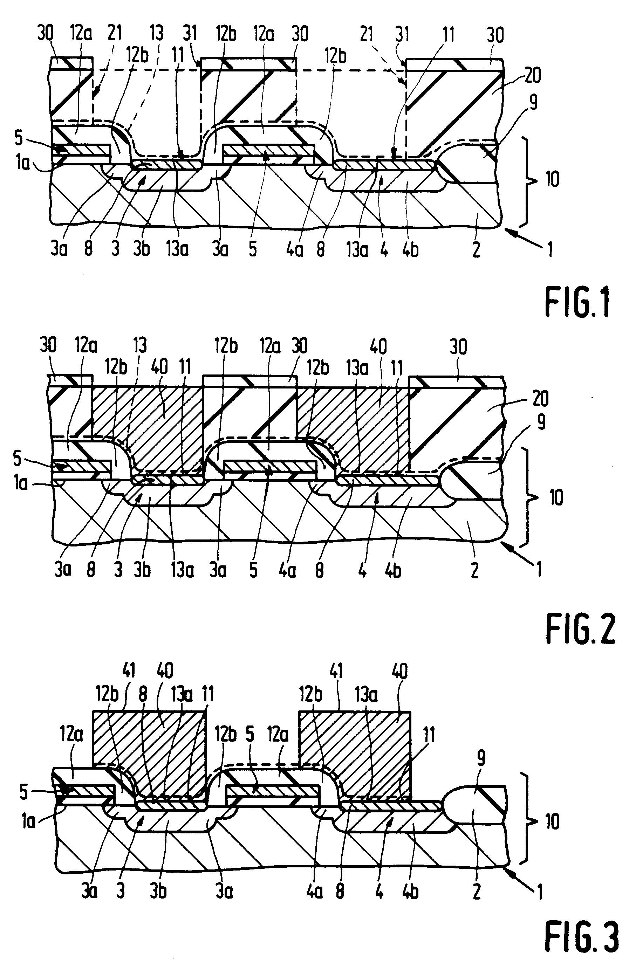

Referring now to the drawings, for example Figures 1 to 5, there is illustrated a method of manufacturing a semiconductor device, which method comprises providing a semiconductor body 1 having adjacent one major surface 1a a device region 3,4 bounded by an insulating region 9,12a,12b, providing electrical connection to the device region by applying a flowable insulating organic material to form an organic insulating layer 20 on the one major surface, defining a masking layer 30 over the organic layer 20, etching the organic insulating layer 20 selectively with respect to the underlying device and insulating regions through a window 31 in the masking layer 30 to form an opening 21 exposing a contact area 11 of the device region 3,4 depositing electrically conductive material, for example tungsten, to form a conductive pillar 40 (Figure 2) within the opening 21 in contact with the contact area 11 and removing the masking layer 30.

In accordance with the invention, the method further comprises, as shown in Figure 3, removing the organic insulating layer 20 so that the side surfaces of the conductive pillar 40 are exposed, providing a layer 50 of insulating material over the pillar 40, etching the insulating layer to expose a top surface 41 of the pillar and depositing electrically conductive material 60 to contact the pillar 40.

Using a method embodying the invention enables the advantages of using a flowable organic material such as polyimide to be obtained, namely the fact that the application of a flowable organic material enables the contact hole or opening 21 to be etched with a high selectivity (in practice almost infinite selectivity) so that very little, if any, of the material comprising the underlying device and insulating regions is removed by the etching of the opening or contact hole 21, whilst avoiding or at least reducing the problems of cracking and/or contamination which may occur when a flowable material such as polyimide is used as an insulating layer.

Turning now specifically to Figure 1, the semiconductor device comprises a monocrystalline silicon semiconductor body 1 having adjacent one major surface 1a of the semiconductor body 1 a relatively lowly doped region 2 of the one conductivity type, in this example p-conductivity type, within which more highly doped device regions 3,4 of the opposite conductivity type, in this example n-conductivity type, are provided adjacent the one surface 1a. Although only two device regions 3,4 are shown in Figure 1, it will be appreciated that the semiconductor body 1 will have many such device regions provided therein. In this example, the device regions 3,4 are associated with insulated gate structures 5 provided on the one surface 1a to form insulated gate field effect transistors (IGFETs). The device regions 3,4 mentioned above, being of n-conductivity type form n-channel IGFETs. However, as will be appreciated by those skilled in the art, the semiconductor body may also contain p-channel IGFETs, so as to form a CMOS integrated circuit, with the p-channel IGFETs being formed by p-conductivity type device regions provided within an n-conductivity type well and, of course, associated insulated gates.

The devices described above are formed in the semiconductor body 1 by, after definition of a field oxide pattern (part of an insulating region 9 of which is shown in Figure 1) by conventional local oxidation of silicon (LOCOS) techniques, forming the insulated gates 5 in conventional manner by growing a gate oxide layer on the surface 1a and then providing a doped polycrystalline silicon layer on the gate oxide layer. The doped polycrystalline silicon layer is locally capped by an insulating region 12a of, for example, silicon oxide and/or silicon nitride. After patterning by conventional photolithographic and etching techniques to define the insulated gates 5, lowly doped extension regions 3a,4a of the device regions 3,4 are formed in self-aligned manner using the insulated gates 5 and the field oxide pattern 9 as a mask.

A silicon oxide or silicon nitride layer 12 is then deposited by a conventional chemical vapour deposition technique and etched using a suitable known anisotropic etching process to provide, as shown in Figure 1, insulating spacer regions 12b on the side walls of the insulated gates 5 which together with the insulating capping regions 12a encapsulate the insulated gates 5 to avoid undesired shorting between the insulated gates 5 and the device regions 3,4 by subsequent metallisation, and to expose the contact areas 11 of the device regions 3,4. The insulated gates 5 shown in Figure 1 are both encapsulated by local insulating capping regions 12a and insulating spacer regions 12b. However, other insulated gates (not shown) of the device may not be provided with an insulating capping region 12a.

After formation of the insulating spacer regions 12b, more highly doped regions 3b, 4b of the device regions 3,4 are formed in conventional self-aligned manner using the insulated gates 5, spacer regions 12b and field oxide insulating region 9 as a mask.

In order to improve ohmic contact to the device regions 3,4, silicide regions 8, for example titanium or cobalt silicide, may be formed at the surfaces of the device regions 3,4 in known manner by depositing a titanium or cobalt layer on the exposed silicon surfaces and heating.

The above-described structure shown in Figure 1 constitutes a substructure 10 to which, in this example, electrical connection is to be made.

The flowable material is then spun onto the one major surface 1a as, in this example, a layer 20 of polyimide to an average thickness which is of course determined by the surface structure. In this example, where the pitch is about 1.2 micrometres, the width of the insulated gates 5 is about 0.55 micrometres and the height of the step defined by the insulated gates 5 and covering insulating capping regions 12a is about 0.5 micrometres (the insulating capping regions 12a being about 0.2 micrometres thick), then the polyimide may have a thickness of about 0.7 micrometres. The polyimide layer 20 is cured for, for example, about 30 minutes at 400 degrees Celsius.

The masking layer 30 is deposited at a low temperature. The masking layer 30 may be a low temperature oxide, a low temperature borophosphosilicate glass or a silicon oxide or silicon nitride formed by a conventional low temperature, about 300 to 350 degrees Celsius, plasma enhanced chemical vapour deposition process. Alternatively, a spin-on-glass may be used to form the masking layer 30.

The masking layer 30 is patterned using conventional photolithographic and fluorine-based dry etching techniques to provide the windows 31 over the contact areas 11 (two of which are shown in the Figures).

As indicated by the phantom lines in Figure 1, the polyimide first insulating layer 20 exposed through the windows 31 is then etched by a suitable anisotropic etching process to form the openings 21 exposing the contact areas 11. In this example, a reactive ion etching process is used which employs an oxygen plasma with a small quantity of fluorine added to enhance the etch rate and prevent, or at least reduce, polymer residues. The amount of fluorine used is adjusted in such a way as to maintain a good etch selectivity of the organic layer 20 with respect to the masking layer 30.

Conductive pillars 40 are then formed by filling the openings 21 with tungsten using a selective process which causes the tungsten to be deposited on the exposed silicon or silicide surface regions but not on the masking layer 30. The tungsten may be deposited by a suitable chemical vapour deposition process using WF₆ and H₂, for example as described in EP-A-0195977, or WF₆ with silane.

In order to obtain growth of the tungsten pillar on the surface of the insulating spacer regions 12b, a nucleation layer 13 (shown in phantom lines in the Figures), for example a layer of amorphous silicon or a titanium- tungsten alloy, may be deposited on the substructure 10 prior to the application of the flowable organic layer 20. Such a nucleation layer should also facilitate adhesion of the tungsten to the contact area 11.

The use of a flowable organic material such as polyimide to form the layer 20 means that the surface of the organic layer is relatively flat or planar and that moreover the conductive pillars 40, if formed by a blanket deposition technique, will have top surfaces 41 which lie on a relatively flat surface. However, polyimide is susceptible to cracking and also to contamination and therefore may not form a sufficiently good insulating layer. Accordingly, after selective deposition of the tungsten to form the conductive pillars 40, the organic layer 20 and the masking layer 30 are removed using, for example, wet chemical etching with HF solutions or plasma etching in a fluorine environment to remove the masking layer 30 and, for example, an oxygen plasma etching process or a wet chemical etching process using HNO₃, H₂N₂ to remove the polyimide layer 20. This has the advantage that the polyimide may be removed with high selectivity relative to the tungsten pillars 40 and oxide.

Where the nucleation or adhesion layer 13 is provided then the exposed portions are removed, by conventional means, after removal of the polyimide layer 20. The removal of the polyimide layer 20 thus enables the use of a nucleation layer 13 which extends (as shown in phantom lines in Figures 1 and 2) over the entire surface and in particular onto the insulating spacer regions 12a, capping insulating regions 12b and field oxide insulating regions 9 to enable growth of tungsten over insulating material such as silicon oxide allowing the conductive pillars 40 to overlap adjacent insulating material without causing short-circuits which might otherwise arise if the polyimide layer 20, and thus necessarily the nucleation layer 13, were to remain in place after formation of the conductive pillars 40. Figure 3 shows the structure after removal of the polyimide first insulating layer 20 with the remaining portions 13a of the nucleation layer beneath the conductive pillars 40.

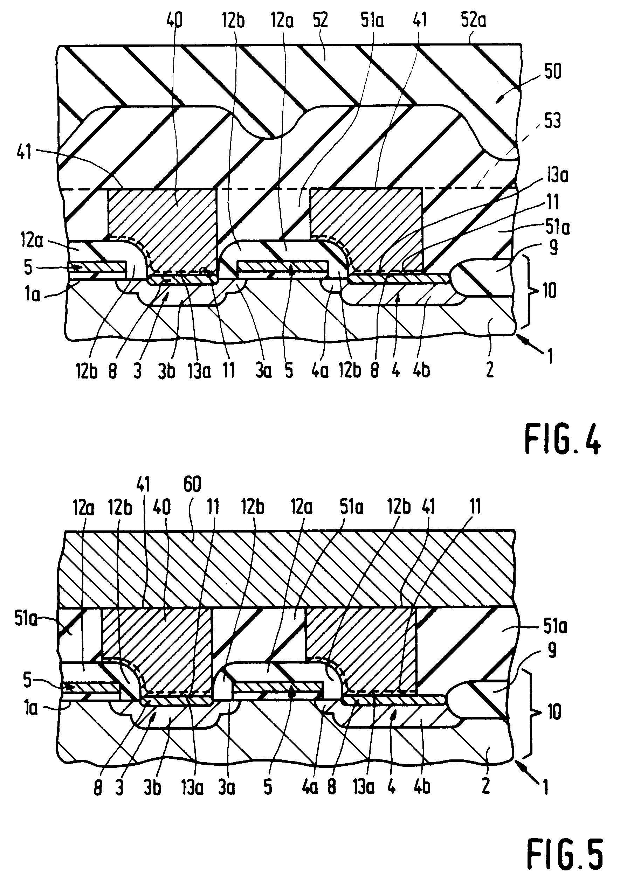

As shown in Figure 4, the further insulating layer 50 is then provided so as to cover the entire structure on the one major surface 1a. In this example, the further insulating layer 50 is formed by first depositing a layer 51 of insulating material, for example using tetra-ethyl-ortho-silicate (TEOS), which follows the contours of the surface and then applying a photosensitive resist layer 52 which, being a flowable material, provides a relatively flat surface 52a. The further insulating layer 50 is then etched back using an etchant, such as a CF₄/O₂ plasma, which etches the photosensitive resist and the silicon oxide layer at substantially the same rate until the top surfaces 41 of the pillars 40 are exposed. The dashed line 53 in Figure 4 illustrates the surface of the further insulating layer 50 after this etch-back process. The etch-back process thus completely removes the photosensitive resist layer 52 and leaves a relatively flat surface in which the conductive pillars 40 are bounded and isolated by the remaining portions 51a of the insulating layer 51 so that a relatively flat surface is provided whilst avoiding or at least reducing the cracking and contamination problems which may arise when polyimide is used as the insulating material. Electrically conductive material 60, for example aluminium, is then deposited so as to contact the conductive pillars 40. The electrically conductive material 60 may then be patterned using conventional photolithographic and etching processes to provide the desired electrical connections between conductive pillars.

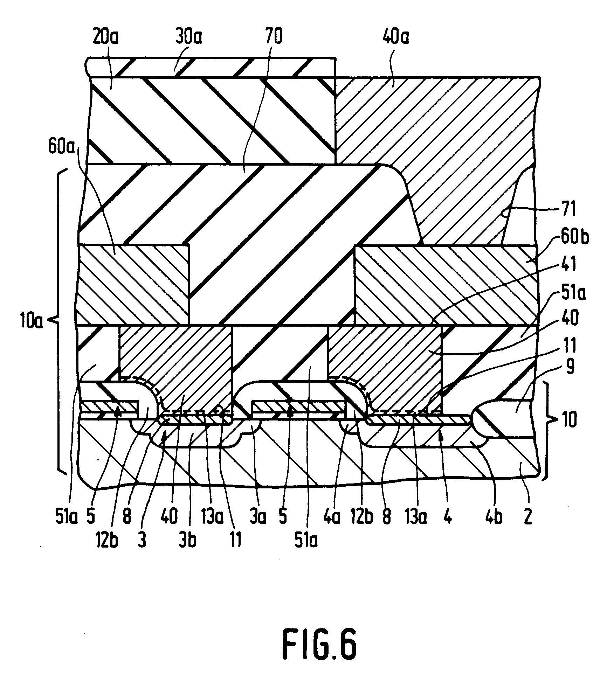

Figure 6 shows an arrangement in which the electrically conductive material 60 has been patterned to define separate conductive tracks 60a,60b contacting the two conductive pillars 40 shown in the Figures. Such an arrangement may, for example, be appropriate when the device regions 3 and 4 shown in the Figures form the source and drain regions of the same IGFET.

As shown in Figure 6, the metallisation level 60 may be covered by another insulating layer, for example a silicon oxide layer 70 deposited by chemical vapour deposition which is subsequently patterned to define openings 71 (only one is shown) through which a further metallisation level (not shown) is to contact the metallisation level 60. The method described above with reference to Figures 1 to 5 may then be used to enable electrical connection between desired conductive tracks of the two metallisation levels so that, as shown in Figure 6, a further polyimide layer 20a and covering masking layer 30a are provided on the surface of the other insulating layer 70 and a conductive pillar 40a is formed within the opening 71. The method then proceeds as described above with reference to Figures 3 to 5 but with the substructure 10 shown in Figures 1 to 5 replaced by the substructure 10a shown in Figure 6. The method may be repeated for further metallisation levels.

The use of the organic layer 20 enables the openings or contact holes 21 to be etched with very high selectivity (in practice effectively infinite selectivity) with respect to the underlying device regions 3,4 and insulating regions 12a,12b,9 so that very little of the underlying material is etched during formation of the contact holes or openings 21. The nucleation layer 13 can be provided beneath the organic layer 20 to enable growth of the conductive pillar 40 on adjacent insulating material because exposed portions of the nucleation layer 13 can be removed after removal of the organic layer 20 so avoiding possible short-circuits. Thus, because the process used to open the contact holes 21 does not attack underlying device regions and gate or field isolation and growth of the conductive material on insulating material is facilitated, the conductive pillars 40 can extend or overlap onto adjacent field oxide insulating regions 9 or insulating regions 12a, 12b without risk of undesired shorting of, for example, a device region 3,4 contacted by a pillar 40 to, for example, an insulated gate 5 or a connecting conductive strap (not shown) on the field oxide 9. The method is thus more tolerant of misalignment of the contact holes or openings 21 than conventional methods.

## Claims

1. A method of manufacturing a semiconductor device, which method comprises providing a semiconductor body having adjacent one major surface a device region bounded by an insulating region, providing an electrical connection to the device region by applying a flowable organic insulating material to form an organic insulating layer on the one major surface, defining a masking layer over the organic insulating layer etching the organic insulating layer selectively with respect to the underlying device and insulating regions through a window in the masking layer to form an opening through the organic insulating layer which exposes a contact area of the device region, selectively depositing electrically conductive material in the opening to form within the opening a conductive pillar contacting the contact area, removing the masking layer, removing the organic insulating layer so that the side surfaces of the conductive pillar are exposed, providing a layer of insulating material to cover the pillar, etching back the insulating layer to expose a top surface of the pillar and depositing electrically conductive material to contact the pillar.

2. A method according to Claim 1, further characterised by using polyimide as the flowable organic insulating material.

3. A method according to Claim 2, further characterised by defining the masking layer as a layer of a material selected from the group consisting of silicon oxide, silicon nitride borophosphosilicate glass and spin-on-glass and etching the organic insulating layer through the masking layer by using a reactive ion etching process.

4. A method according to Claim 1, 2 or 3, further characterised by selectively depositing tungsten to form the conductive pillar.

5. A method according to Claim 4, further characterised by providing a nucleation layer over the one major surface prior to applying the flowable organic insulating material and removing exposed parts of the nucleation layer after removing the organic insulating layer.

6. A method according to any one of the preceding claims, further characterised by providing the insulating layer by depositing a layer of silicon oxide, applying a resist layer on the silicon oxide layer to provide a flatter surface and then etching the insulating layer so that the silicon oxide and resist are etched at the same rate thereby providing a relatively flat surface upon exposure of the top surface of the conductive pillar.

## Patentansprüche

1. Verfahren zur Herstellung einer Halbleitervorrichtung, welches einen Halbleiterkörper vorsieht, der neben einer Hauptoberfläche eine durch eine Isolierzone abgegrenzte Device-Zone aufweist, welches eine elektrische Verbindung mit der Device-Zone durch Aufbringen eines organischen, fließfähigen Materials zur Herstellung einer organischen Isolierschicht auf einer Hauptoberfläche vorsieht, bei welchem über der organischen Isolierschicht eine Maskierungsschicht ausgebildet ist, die organische Isolierschicht gegenüber der darunterliegenden Vorrichtung und den Isolierzonen durch ein Fenster in der Maskierungsschicht selektiv weggeätzt wird, um eine Öffnung durch die organische Isolierschicht herzustellen, welche eine Kontaktfläche der Device-Zone freilegt, elektrisch leitendes Material in der Öffnung selektiv abgeschieden wird, um in der Öffnung einen, die Kontaktfläche kontaktierenden, leitenden Kontakthöcker herzustellen, die Maskierungsschicht und die organische Isolierschicht abgetragen und dadurch die Seitenflächen des leitenden Kontakthöckers freigelegt werden, der Kontakthöcker mit einer Schicht aus Isoliermaterial versehen wird, eine Rückätzung der Isolierschicht zwecks Freilegung einer Oberseite des Kontakthöckers erfolgt und elektrisch leitendes Material abgeschieden wird, um einen Kontakt mit dem Kontakthöcker herzustellen.

2. Verfahren nach Anspruch 1, in welchem Polyimid als fließfähiges, organisches Isoliermaterial verwendet wird.

3. Verfahren nach Anspruch 2, in welchem die Maskierungsschicht als eine aus Siliziumoxid, Siliziumnitrid, Borophosphosilikatglas und aufzuschleuderndes Glas bestehende Schicht ausgebildet ist und die organische Isolierschicht durch die Maskierungsschicht unter Anwendung eines reaktiven lonenätzverfahrens geätzt wird.

4. Verfahren nach Anspruch 1, 2 oder 3, in welchem Wolfram zur Herstellung des leitenden Kontakthöckers selektiv abgeschieden wird.

5. Verfahren nach Anspruch 4, in welchem über einer Hauptoberfläche eine Kernbildungsschicht vor Aufbringen des fließfähigen, organischen Materials vorgesehen wird und die freigelegten Teile der Kernbildungsschicht nach Abtragen der organischen Isolierschicht entfernt werden.

6. Verfahren nach einem der vorangegangenen Verfahren, in welchem die Isolierschicht durch Abscheidung einer Schicht aus Siliziumoxid vorgesehen, eine Fotolackschicht auf die Siliziumoxidschicht aufgebracht wird, um eine ebenere Oberfläche vorzusehen und sodann die Isolierschicht so geätzt wird, daß Siliziumoxid und Fotolack in gleichem Maße geätzt werden und auf diese Weise bei Freilegen der Oberfläche des leitenden Kontakthöckers eine relativ ebene Oberfläche vorgesehen wird.

## Revendications

1. Procédé de fabrication d'un dispositif à semi-conducteurs, lequel procédé comprend la fourniture d'un corps semi-conducteur présentant, à côté d'une surface principale, une zone de dispositif limitée par une zone d'isolation, la fourniture d'une connexion électrique à la zone du dispositif par application d'un matériau organique d'isolation capable de fluer, afin de former une couche organique d'isolation sur cette surface principale, la définition d'une couche de masquage sur la couche organique d'isolation, l'attaque de la couche organique isolante sélectivement par rapport au dispositif sous-jacent et aux zones d'isolation à travers une fenêtre dans la couche de masquage afin de former une ouverture à travers la couche isolante organique qui expose une surface de contact de la zone de dispositif, le dépôt sélectif d'un matériau électriquement conducteur afin de former à l'intérieur de l'ouverture un pilier conducteur en contact avec la surface de contact, l'enlèvement de la couche de masquage, l'enlèvement de la couche organique d'isolation de façon à ce que les surfaces latérales du pilier conducteur soient exposées, le dépôt d'une couche d'un matériau isolant recouvrant le pilier, l'attaque en retour de la couche d'isolation afin d'exposer la surface supérieure du pilier et le dépôt d'un matériau électriquement conducteur en contact avec le pilier.

2. Procédé suivant la revendication 1, caractérisé en plus par l'emploi de polyimide comme matériau organique d'isolation capable de fluer.

3. Procédé suivant la revendication 2, caractérisé en plus par le fait que la couche de masquage est une couche d'un matériau sélectionné parmi le groupe comprenant l'oxyde de silicium, le nitrure de silicium, le verre borophosphosilicaté et le verre centrifugé et par l'attaque de la couche organique d'isolation à travers la couche de masquage à l'aide d'un procédé d'attaque par ion réactif.

4. Procédé suivant la revendication 1, 2 ou 3, caractérisé en plus par le dépôt sélectif de tungstène afin de former le pilier conducteur.

5. Procédé suivant la revendication 4, caractérisé en plus par le dépôt d'une couche de nucléation sur la surface principale avant l'application du matériau organique d'isolation capable de fluer et l'enlèvement des parties exposées de la couche de nucléation après enlèvement de la couche organique d'isolation.

6. Procédé suivant l'une quelconque des revendications précédentes, caractérisé en plus par l'application d'une couche d'isolation par dépôt d'une couche d'oxyde de silicium, l'application d'un agent photorésistant sur la couche d'oxyde de silicium afin d'obtenir une surface plus plane et ensuite l'attaque de la couche d'isolation de façon à attaquer l'oxyde de silicium et l'agent photorésistant à la même vitesse, ceci fournissant une surface relativement plane après exposition de la surface supérieure du pilier conducteur.
